# EUROPEAN PATENT APPLICATION

(11) **EP 3 544 059 A1**
(43) Date of publication of application: **25.09.2019**
(21) Application number: 19173752.7
(22) Date of filing: 19.01.2017
(51) Int. Cl.: H01L 31/0224, H01L 31/0747

(54) **SOLAR CELL**

(30) Priority: 20.01.2016 KR 20160006863
(62) Divisional of application: 17152171.9
(71) Applicant: LG ELECTRONICS INC., 07336 SEOUL (KR)
(72) Inventor: LEE, Seungyoon, 08592 Seoul (KR); JI, Kwangsun, 08592 Seoul (KR); LEE, Hongcheol, 08592 Seoul (KR); HWANG, Sunghyun, 08592 Seoul (KR)
(74) Representative: Katérle, Axel

(57) **Abstract**

A solar cell is disclosed, which includes a crystalline semiconductor substrate of a first conductive type, a front doped layer on a front surface of the semiconductor substrate and forming a hetero junction with the semiconductor substrate, a back doped layer on a back surface of the semiconductor substrate and forming a hetero junction with the semiconductor substrate, a front transparent conductive layer on the front doped layer, a back transparent conductive layer under the back doped layer. One of the front doped layer and the back doped layer has a second conductive type opposite to the first conductive type to form a p-n junction with the semiconductor substrate, and the other of the front doped layer and the back doped layer has the first conductive type. A planar area of the front transparent conductive layer is larger than a planar area of the back transparent conductive layer.

## Description

### CROSS-REFERENCE TO RELATED APPLICATION

This application claims priority to and the benefit of Korean Patent Application No. 10-2016-0006863 filed in the Korean Intellectual Property Office on January 20, 2016, the entire contents of which are incorporated herein by reference.

### BACKGROUND OF THE INVENTION

### Field of the Invention

Embodiments of the invention relate to a solar cell, and more particularly to a hetero-junction solar cell.

### Background of the Related Art

Recently, research on hetero-junction solar cells has been progressing in order to improve the efficiency of solar cells. Representative hetero-junction solar cells include solar cells using intrinsic-amorphous silicon (i-a-Si) as a passivation layer, and solar cells using a thin tunnel oxide layer as a passivation layer.

The hetero-junction solar cells are formed on front and back surfaces of a semiconductor substrate for a solar cell and include a transparent conductive oxide (TCO) layer that performs an optical function (for example, a function of an anti-reflection layer and a reflection layer) and an electrical function (for example, a contact function with a metal electrode).

When a front transparent conductive layer located on the front surface of the semiconductor substrate and a back transparent conductive layer located under the back surface of the semiconductor substrate physically come into contact with each other, there is a problem that the shunt resistance is lowered, the conversion efficiency is lowered, and a short circuit occurs.

Accordingly, a related art solar cell was configured such that a transparent conductive layer was not formed in the front edge region and the back edge region of the semiconductor substrate but only in the center region except for the edge region.

However, in the solar cell having such a structure, since the front transparent conductive layer is not formed in the edge region, the anti-reflection function of the front transparent conductive layer is deteriorated, and currents generated in the semiconductor substrate of the edge region are not collected on the collector electrode. Therefore, there is a problem that the short-circuit current density is reduced and thus the efficiency of the solar cell is lowered.

### SUMMARY OF THE INVENTION

An object of the invention is to provide a high-efficiency solar cell.

In one aspect, there is provided a solar cell including a crystalline semiconductor substrate of a first conductive type; a front doped layer located on a front surface of the semiconductor substrate and forming a hetero junction with the semiconductor substrate; a back doped layer located on a back surface of the semiconductor substrate and forming a hetero junction with the semiconductor substrate; a front transparent conductive layer located on the front doped layer; and a back transparent conductive layer located under the back doped layer. One of the front doped layer and the back doped layer has a second conductive type opposite the first conductive type to form a p-n junction with the semiconductor substrate, and the other of the front doped layer and the back doped layer has the first conductive type. A planar area of the front transparent conductive layer is larger than a planar area of the back transparent conductive layer.

A width in a first direction of the front transparent conductive layer may be equal to or greater than a width in the first direction of the semiconductor substrate.

The front transparent conductive layer may be not formed in at least a part of an edge region of the front surface of the semiconductor substrate.

A region where the front transparent conductive layer is not formed may be locally located in a part of the edge region of the front surface of the semiconductor substrate.

A plurality of regions where the front transparent conductive layer is not formed may be spaced apart from each other.

A width in the first direction and a width in a second direction of the back transparent conductive layer may be less than the width in the first direction and a width in the second direction of the semiconductor substrate, respectively.

The back transparent conductive layer may be not formed in an edge region of the back surface of the semiconductor substrate.

A region where the back transparent conductive layer is not formed may be continuously formed along an edge of the semiconductor substrate.

In an embodiment of the invention, each of the front surface and the back surface of the semiconductor substrate may include an edge region that is continuously formed from an edge of the semiconductor substrate to inside of the semiconductor substrate along the edge and a center region that is a remaining region except for the edge region. The front transparent conductive layer may be formed entirely in the edge region and the center region of the front surface of the semiconductor substrate, or formed in the center region and a remaining edge region except for a non-formed portion formed discontinuously in a part of the edge region of the front surface. The back transparent conductive layer may be formed only in the center region except for the edge region of the back surface.

According to the solar cell having such a configuration, the physical connection or physical contact between the front transparent conductive layer and the back transparent conductive layer is completely prevented and the size of the front transparent conductive layer located on the front surface of the semiconductor substrate on which light is incident can be maximized.

Therefore, it is possible to achieve a high efficiency of the solar cell.

A width of the edge region of the back surface of the semiconductor substrate may be 0.5 mm to 1.5 mm, for example, 0.5 mm to 1.0 mm.

At least one of the front surface and the back surface of the semiconductor substrate may be formed as a texturing surface including a plurality of fine unevenness.

The semiconductor substrate contains an n-type impurity, the front doped layer may be formed of p-type amorphous silicon containing a p-type impurity, and the back doped layer may be formed of n-type amorphous silicon containing an n-type impurity.

A solar cell according to an embodiment of the invention may further include a front collector electrode located on the front transparent conductive layer and a back collector electrode located under the back transparent conductive layer. The front collector electrode may be not physically and directly in contact with the front doped layer and the back collector electrode may be not physically and directly in contact with the back doped layer.

According to this structure, defects can be prevented from being generated in the doped layer when the electrode (e.g., a metal material) is baked.

The front collector electrode may include a plurality of first finger electrodes extending in the first direction, and at least one first bus bar electrode extending in the second direction orthogonal to the first direction and physically connected to the plurality of first finger electrodes.

The back collector electrode may include a plurality of second finger electrodes extending in the first direction and at least one second bus bar electrode extending in the second direction and physically connected to the plurality of second finger electrodes, or include a sheet electrode which covers entirely the back surface of the back transparent conductive layer.

According to an embodiment of the invention, the non-formed portion may be located at both ends of the at least one first bus bar electrode.

A width in the first direction of the both ends of the at least one first bus bar electrode may be larger than a width in the first direction of a remaining portion located between the both ends along the second direction. Each of the both ends of the at least one first bus bar electrode may be divided into both sides of the non-forming portion along the first direction, and the non-formed portion may be located between the divided both ends.

In this instance, the first finger electrodes may be located on the front transparent conductive layer of the edge region excluding the non-forming portion, and the both ends of the divided at least one first bus bar electrode may extend to the edge region and may be physically connected to the first finger electrodes.

A width in the first direction of the non-formed portion may be less than the width in the first direction of the remaining portion of the at least one first bus bar electrode. A length in the second direction of the non-formed portion may be smaller than an interval between two first finger electrodes that is adjacent to each other in the second direction.

A solar cell according to an embodiment of the invention may further include a front passivation layer located between the front doped layer and the semiconductor substrate, and a back passivation layer located between the back doped layer and the semiconductor substrate. The front passivation layer and the back passivation layer may be formed of intrinsic amorphous silicon or a tunnel oxide.

At least one of the front passivation layer, the back passivation layer, the front doped layer, and the back doped layer may be further located on a side surface of the semiconductor substrate. The front passivation layer, the back passivation layer, the front doped layer, and the back doped layer may overlap each other on the side surface of the semiconductor substrate. As described above, when the front passivation layer, the back passivation layer, the front doped layer, and the back doped layer overlap each other on the side surface of the semiconductor substrate, a passivation effect on the side surface of the semiconductor substrate can be obtained. Of course, even if only the front passivation layer and the back passivation layer overlap each other on the side surface of the semiconductor substrate, and the front doped layer and the back doped layer are not located further on the side surface of the semiconductor substrate, a passivation effect can be obtained by the front passivation layer and the back passivation layer which overlap each other on the side surface of the semiconductor substrate.

In this instance, the front transparent conductive layer may be further located on the front passivation layer, the back passivation layer, the front doped layer, and the back doped layer, which overlap each other on the side surface of the semiconductor substrate.

In a solar cell according to an embodiment of the invention, the physical connection or physical contact between the front transparent conductive layer and the back transparent conductive layer is completely prevented and the size of the front transparent conductive layer located on the front surface of the semiconductor substrate on which light is incident can be maximized. Therefore, it is possible to achieve a high efficiency of the solar cell.

### BRIEF DESCRIPTION OF THE DRAWINGS

FIG. 1 is a front view and a back view of a solar cell according to a first embodiment of the invention.
FIG. 2 is a cross-sectional view of a solar cell shown in FIG. 1 cut along line II-II.
FIG. 3 is a front view and a back view showing a state in which a front collector electrode and a back collector electrode are removed from a solar cell shown in FIG. 1.
FIG. 4 is a front view of a solar cell according to a second embodiment of the invention.
FIG. 5 is a front view showing a state in which a front collector electrode is removed from the solar cell shown in FIG. 4.
FIG. 6 is a cross-sectional view of a solar cell according to a third embodiment of the invention.
FIG. 7 is a device for forming a transparent conductive layer of the solar cell shown in FIG. 1, and a conceptual diagram of a sputtering device capable of simultaneous deposition on both surfaces.
FIG. 8 illustrates a device for forming a transparent conductive layer of the solar cell shown in FIG. 4, and a conceptual diagram of a remote plasma deposition (RPD) device capable of depositing both surfaces using flipping.

### DETAILED DESCRIPTION OF THE EMBODIMENTS

Reference will now be made in detail to embodiments of the invention examples of which are illustrated in the accompanying drawings. Since the invention may be modified in various ways and may have various forms, specific embodiments are illustrated in the drawings and are described in detail in the specification. However, it should be understood that the invention are not limited to specific disclosed embodiments, but include all modifications, equivalents and substitutes included within the spirit and technical scope of the invention.

The terms 'first', 'second', etc., may be used to describe various components, but the components are not limited by such terms. The terms are used only for the purpose of distinguishing one component from other components.

For example, a first component may be designated as a second component without departing from the scope of the embodiments of the invention. In the same manner, the second component may be designated as the first component.

The term "and/or" encompasses both combinations of the plurality of related items disclosed and any item from among the plurality of related items disclosed.

When an arbitrary component is described as "being connected to" or "being linked to" another component, this should be understood to mean that still another component(s) may exist between them, although the arbitrary component may be directly connected to, or linked to, the second component.

On the other hand, when an arbitrary component is described as "being directly connected to" or "being directly linked to" another component, this should be understood to mean that no other component exists between them.

The terms used in this application are used to describe only specific embodiments or examples, and are not intended to limit the invention. A singular expression can include a plural expression as long as it does not have an apparently different meaning in context.

In this application, the terms "include" and "have" should be understood to be intended to designate that illustrated features, numbers, steps, operations, components, parts or combinations thereof exist and not to preclude the existence of one or more different features, numbers, steps, operations, components, parts or combinations thereof, or the possibility of the addition thereof.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present.

Unless otherwise specified, all of the terms which are used herein, including the technical or scientific terms, have the same meanings as those that are generally understood by a person having ordinary knowledge in the art to which the invention pertains.

The terms defined in a generally used dictionary must be understood to have meanings identical to those used in the context of a related art, and are not to be construed to have ideal or excessively formal meanings unless they are obviously specified in this application.

The following example embodiments of the invention are provided to those skilled in the art in order to describe the invention more completely. Accordingly, shapes and sizes of elements shown in the drawings may be exaggerated for clarity.

Example embodiments of the invention will be described with reference to the accompanying drawings.

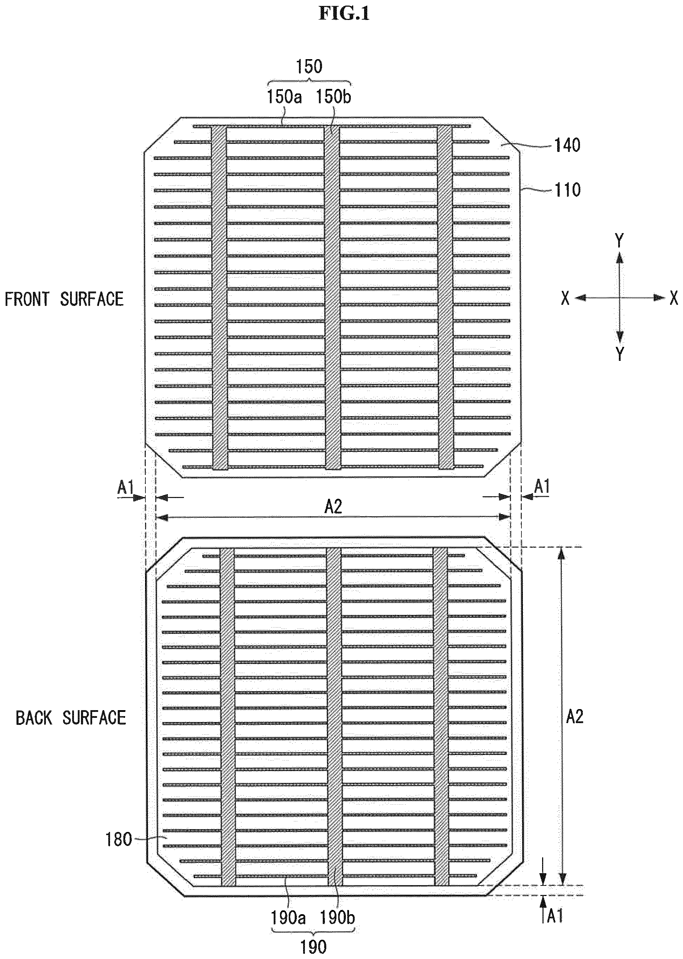

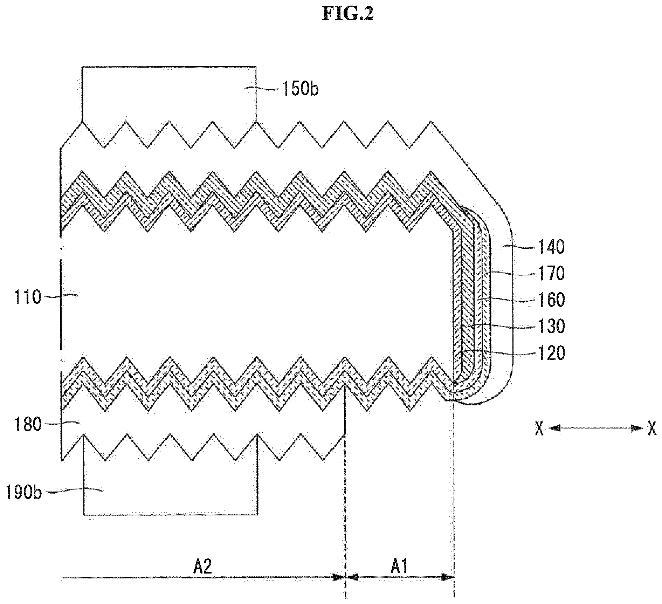

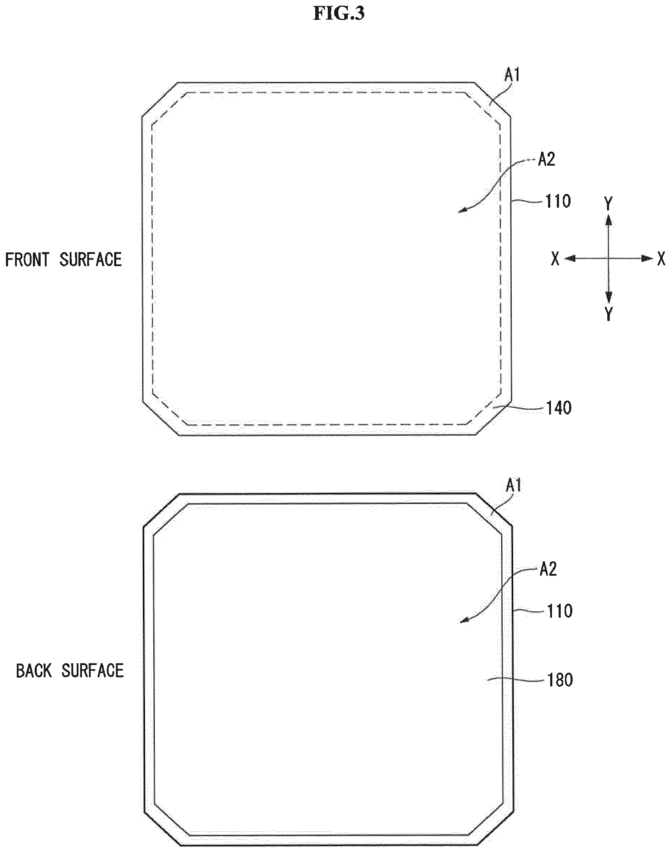

FIG. 1 is a front view and a back view of a solar cell according to a first embodiment of the invention. FIG. 2 is a cross-sectional view of a solar cell shown in FIG. 1 cut along line II-II in the X-X direction. FIG. 3 is a front view and a back view showing a state in which a front collector electrode and a back collector electrode are removed from a solar cell shown in FIG. 1.

As shown in FIGS. 1 to 3, a solar cell according to the first embodiment of the invention includes a crystalline semiconductor substrate 110.

A front passivation layer 120, a front doped layer 130, a front transparent conductive layer 140, and a front collector electrode 150 are sequentially stacked on the front surface (or a light incident surface) of the semiconductor substrate 110. A back passivation layer 160, a back doped layer 170, a back transparent conductive layer 180, and a back collector electrode 190 are sequentially stacked on the back surface of the semiconductor substrate 110.

Hereinafter, the "front surface" refers to an upward facing surface in the accompanying drawings. The "back surface" refers to a downward facing surface in the accompanying drawings. The "side surface" refers to a surface facing both left and right sides in the accompanying drawings. The "front surface" refers to a surface on which a transparent conductive layer having a relatively wide width is located among the transparent conductive layers 140 and 180. The surface on which the transparent conductive layer having a relatively wide width is located can be used as the front surface or the light incidence surface.

The substrate 110 is a semiconductor substrate 110 made of crystalline silicon containing impurities of a first conductive type, for example, an n-type. In this instance, the silicon may be single crystal silicon or polycrystalline silicon.

Since the substrate 110 has an n-type, the substrate 110 contains impurities of a Group V element such as phosphorus (P), arsenic (As), antimony (Sb), and the like.

Alternatively, however, the substrate 110 may be a p-type and may be made of a semiconductor material other than silicon. When the substrate 110 has a p-type, the substrate 110 may contain impurities of a Group III element such as boron (B), gallium (Ga), indium (In), and the like.

Hereinafter, a case that the substrate 110 has an n-type will be described as an example.

The substrate 110 has a texturing surface whose surface is textured. More specifically, the substrate 110 includes a front surface on which the front passivation layer 120 is located and a back surface on which the back passivation layer 160 is located as texturing surfaces.

Alternatively, the back surface of the semiconductor substrate 110 may be formed as a substantially flat surface without fine unevenness.

The front passivation layer 120 located on the front surface of the semiconductor substrate 110 and the back passivation layer 160 located on the back surface of the semiconductor substrate 110 may be formed of substantially intrinsic i-type amorphous silicon (i-a-Si) or may be formed of a tunnel oxide.

The front passivation layer 120 may extend to the side surface of the substrate 110 and the back passivation layer 160 may extend to the side surface of the substrate 110. In this instance, the front passivation layer 120 and the back passivation layer 160 overlap each other on the side surface of the semiconductor substrate 110. Therefore, since the passivation effect at the side surface of the semiconductor substrate can be obtained, the passivation effect can be improved as compared with the instance where the side surface of the semiconductor substrate is not covered with the front and back passivation layers. In this instance, "overlap each other" refers to a state in which at least a part of the front passivation layer and the back passivation layer overlaps each other on a projection surface when viewed from the side surface of the semiconductor substrate.

The front doped layer 130 located on the front passivation layer 120 is an impurity portion having a second conductive type, for example, a p-type opposite the conductive type of the substrate 110. The front doped layer 130 is made of p-type amorphous silicon (p-a-Si) and forms a p-n junction and a hetero junction with the substrate 110.

The back doped layer 170 located under the back passivation layer 160, that is, on the back surface of the semiconductor substrate 110 is an impurity portion having a first conductive type, for example, an n-type, which is the same as the conductive type of the substrate 110. The back doped layer 170 is made of n-type amorphous silicon and forms a hetero junction with the substrate 110.

Alternatively, the front doped layer 130 located on the front surface (or the light incident surface) of the semiconductor substrate may be made of n-type amorphous silicon (n-a-Si). The back doped layer 170 located on the back surface (or the surface opposite to the light incident surface) of the semiconductor substrate may be made of p-type amorphous silicon (p-a-Si).

When the semiconductor substrate 110 and the back doped layer 170 are n-type and the front doped layer 130 is p-type, the separated electrons move toward the back doped layer 170 and the separated holes move toward the front doped layer 130.

Unlike the embodiment, when the substrate 110 and the back doped layer 170 are p-type and the front doped layer 130 is n-type, the separated holes move toward the back doped layer 170, and the separated electrons move toward the front doped layer 130.

Each of the front doped layer 130 and the back doped layer 170 may be formed to extend to the side surface of the semiconductor substrate 110.

Therefore, the front passivation layer 120, the front doped layer 130, the back passivation layer 160, and the back doped layer 170 are sequentially stacked on the side surface of the semiconductor substrate 110 and overlap each other. However, the front doped layer may be formed only on the front surface of the semiconductor substrate, and the back doped layer may be formed only on the back surface of the semiconductor substrate. In this instance, only the front passivation layer and the back passivation layer overlap each other on the side surface of the semiconductor substrate.

Each of the front surface and the back surface of the semiconductor substrate 110 includes an edge region A1 that is continuously formed along an edge from an edge of the semiconductor substrate 110 to inside of the semiconductor substrate 110 and a center region A2 that is a remaining region except for the edge region A1.

In this embodiment, the front transparent conductive layer 140 is formed entirely in the edge region A1 and the center region A2 of the front surface of the semiconductor substrate 110.

In this instance, the term "formed entirely" means that the front transparent conductive film 140 is formed in the edge region A1 and the center region A2 of the front surface of the semiconductor substrate 110 without a region where the front transparent conductive layer 140 is not formed.

The front transparent conductive layer 140 may be formed to extend to the side surface of the semiconductor substrate 110.

In this instance, the front passivation layer 120, the front doped layer 130, the back passivation layer 160, the back doped layer 170, and the front transparent conductive layer 140 are sequentially stacked on the side surface of the semiconductor substrate 110 and overlap each other.

The back transparent conductive layer 180 is formed only in the center region A2 except for the edge region A1 of the back surface of the semiconductor substrate 110. That is, the back transparent conductive layer 180 is not formed in the edge region A1 of the back surface of the semiconductor substrate 110.

Therefore, it is possible to prevent the front transparent conductive layer 140 extending to the side surface of the semiconductor substrate 110 from physically connecting and contacting the back transparent conductive layer 180. Also, as coverage of the front surface of the semiconductor substrate 110 by the front transparent conductive layer 140 may be greater than coverage of the back surface of the semiconductor substrate 110 by the back transparent conductive layer 180, a planar area of the front transparent conductive layer 140 is larger than a planar area of the back transparent conductive layer 180. Also, a width in the first direction of the front transparent conductive layer 140 may be equal to or greater than a width in the first direction of the semiconductor substrate 110. Also, a width in the first direction and a width in a second direction orthogonal to the first direction of the back transparent conductive layer 180 may be less than a width in the first direction and a width in the second direction of the semiconductor substrate 110, respectively.

Table 1 below shows experimental data on characteristics of the solar cell according to the size (width) of the edge region A1 of the back transparent conductive layer 180.

**[Table 1]**

| | Width of edge region of back surface (mm) | Voc (mV) | Jsc (mA/cm²) | FF (%) | Efficiency (%) |
|---|---|---|---|---|---|
| Sample 1 | 0.3 | 706 | 36.3 | 73.0 | 18.6 |
| Sample 2 | 0.5 | 708.0 | 36.1 | 74.9 | 19.1 |
| Sample 3 | 1.0 | 708.1 | 35.7 | 75.0 | 19.0 |
| Sample 4 | 1.5 | 708.6 | 35.2 | 75.1 | 18.7 |
| Sample 5 | 2.0 | 708.5 | 34.7 | 74.8 | 18.4 |

Referring to Table 1 above, the factor that mainly varies according to the size (width) of the edge region A1 of the back surface of the semiconductor substrate is the short circuit current density Jsc. As the size (width) of the edge region A1 of the back surface of the semiconductor substrate decreases from 2.0 mm to 1.0 mm, the short circuit current density increases and the conversion efficiency tends to increase. When the size (width) of the edge region A1 is less than 0.5 mm, for example, when the size (width) of the edge region A1 is 0.3 mm, the fill factor FF decreases rather than the case where the size (width) of the edge region A1 is 0.5 mm and the conversion efficiency decreases.

When the size (width) of the edge region A1 of the back surface of the semiconductor substrate is less than 0.5 mm, in reality, a part of the back transparent conductive layer 180 is electrically connected to the front transparent conductive layer 140 and a shunt resistance is reduced. Thus, the conversion efficiency decreases.

Therefore, the size (width) of the edge region A1 of the back surface of the semiconductor substrate 110 is, for example, 0.5 mm to 1.5 mm, for example, 0.5 mm to 1.0 mm.

The front transparent conductive layer 140 and the back transparent conductive layer 180 may be formed of a layer made of indium oxide (In₂O₃) as a main component containing impurities such as tin (Sn), zinc (Zn), tungsten (W), cerium (Ce) or hydrogen (H), or a layer made of zinc oxide (ZnO) as a main component containing impurities such as aluminum (Al), boron (B), or gallium (Ga), or a layer made of tin oxide (SnO₂) layer as a main component containing impurities such as fluorine (F), or a layer made of indium oxide (In₂O₃) as a main component containing at least one of impurities such as tantalum (Ta) or titanium (Ti).

The front transparent conductive layer 140 and the back transparent conductive layer 180 may be formed of the same material or may be formed of different materials.

In this instance, "the same material" refers to a material having a main component and an impurity identical to each other, and "different materials" refers to a material different from at least one of a main component and an impurity.

The front transparent conductive layer 140 has an anti-reflection function for increasing an amount of light incident on the semiconductor substrate 110, and a function to transfer charges moved to the front doped layer 130 to the front collector electrode 150.

The front transparent conductive layer 140 having the above functions may be formed with a thickness of approximately 70 nm to 100 nm in consideration of anti-reflection characteristics.

The back transparent conductive layer 180 has a back reflect function, and a function to transfer charges moved to the back doped layer 170 to the back collector electrode 190.

The front transparent conductive layer 140 and the back transparent conductive layer 180 may be formed with the same thickness or may be formed with different thicknesses.

The front collector electrode 150 is located on the front transparent conductive layer 140. For example, the front collector electrode 150 is located only in the center region A2 and the edge region A1 of the front surface of the semiconductor substrate 110. That is, the front collector electrode 150 is not located on the side surface of the semiconductor substrate 110. Thus, the front collector electrode 150 is not physically and directly in contact with the front doped layer 130.

The front collector electrode 150 may include a plurality of first finger electrodes 150a extending in a first direction X-X and spaced apart in parallel and at least one bus bar electrode 150b extending in a second direction Y-Y orthogonal to the first direction X-X and physically connected to the plurality of first finger electrodes 150a. The front collector electrode 150 may be formed of a metal having excellent conductivity, for example, silver (Ag).

The back collector electrode 190 is located under the back transparent conductive layer 180, that is, on a lower part thereof. For example, the back collector electrode 190 is located only in the center region A2 of the back surface of the semiconductor substrate 110. That is, the back collector electrode 190 is not located in the edge region A1 of the back surface of the semiconductor substrate 110 and on the side surface of the semiconductor substrate 110. Thus, the back collector electrode 190 is not physically and directly in contact with the back doped layer 170.

The back collector electrode 190 may have the same structure as that of the front collector electrode 150. In this instance, the back collector electrode 190 may include a plurality of second finger electrodes 190a extending in a first direction X-X and spaced apart in parallel and at least one second bus bar electrode 190b extending in a second direction Y-Y and physically connected to the plurality of second finger electrodes 190a. The back collector electrode 190 may be formed of the same material as the front collector electrode 150.

Alternatively, the back collector electrode 190 and the front collector electrode 150 may be formed of different conductive materials.

The second bus bar electrode 190b of the back collector electrode 190 may be located at a position facing the first bus bar electrode 150b of the front collector electrode 150.

The spacing of the second finger electrodes 190a adjacent to each other in the second direction may be greater than the spacing of the first finger electrodes 150a adjacent to each other in the second direction.

As described above, the solar cell in which the front collector electrode 150 and the back collector electrode 190 are formed in the same structure can be used as a bi-facial solar cell.

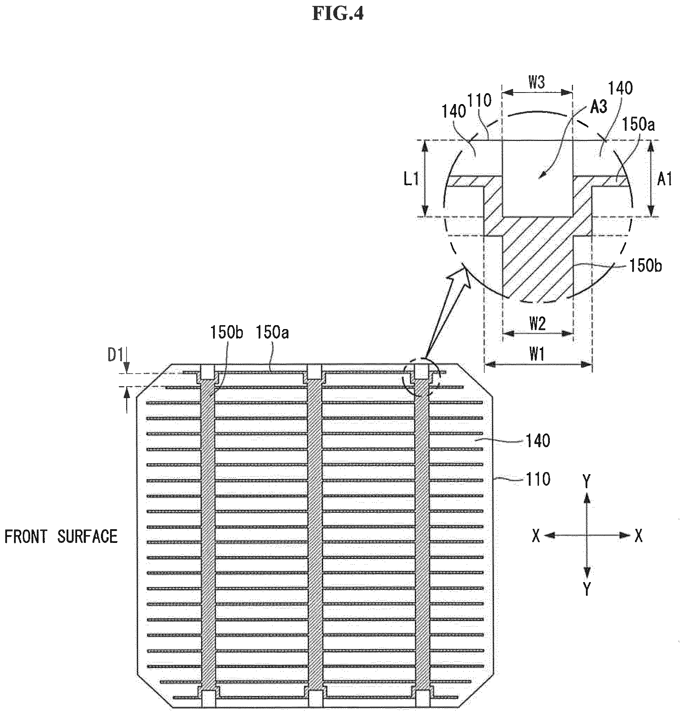

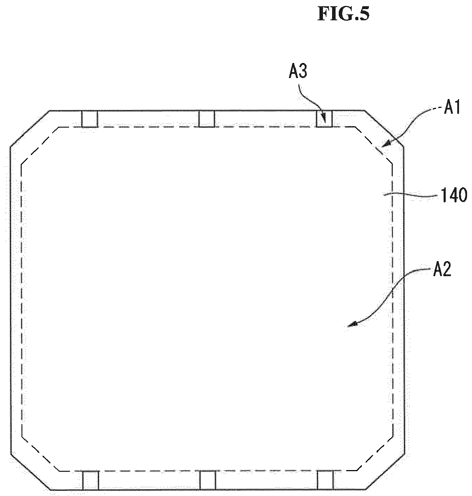

Hereinafter, a solar cell according to a second embodiment of the invention will be described with reference to FIGS. 4 and 5.

FIG. 4 is a front view of a solar cell according to a second embodiment of the invention. FIG. 5 is a front view showing a state in which a front collector electrode is removed from the solar cell shown in FIG. 4.

In describing the solar cell of the second embodiment, since the back surface structure of the solar cell is configured in the same manner as in the first embodiment, hereinafter, only the front structure of the solar cell will be described, and the same reference numerals as those of the first embodiment will not be described.

In the solar cell of the first embodiment, the front transparent conductive layer 140 is entirely formed in the center region A2 and the edge region A1 of the front surface of the semiconductor substrate 110, and extends to the side surface of the semiconductor substrate 110.

However, in the solar cell of this embodiment, the front transparent conductive layer 140 is formed in the center region A2 and a remaining edge region A1 except for a non-formed portion A3 formed discontinuously in a part of the edge region A1 of the front surface of the semiconductor substrate 110.

That is, in this embodiment, in the edge region A1 of the front surface of the semiconductor substrate 110, there is a non-formed portion A3 in which the front transparent conductive layer 140 is not formed. The non-formed portion A3 is discontinuously formed in a part of the edge region A1.

In this instance, "discontinuously formed" refers to a shape in which the non-formed portion A3 is not continuously formed along the edge of the semiconductor substrate 110. One example of such a shape may be an island shape.

Therefore, a certain gap is maintained between the adjacent non-formed portions A3 in the first direction.

For example, the non-formed portion A3 may be located at both ends of the first bus bar electrode 150b.

Since the front collector electrode 150 located on the front surface of the semiconductor substrate 110 blocks the light incident on the semiconductor substrate 110, a shading loss due to the front collector electrode 150 occurs.

The first bus bar electrode 150b of the front collector electrode 150 is connected to a wiring for electrical connection with a neighboring solar cell. The wiring extends toward the neighboring solar cell.

Therefore, since light cannot be incident on the region where the front collector electrode 150 and the wiring for electrical connection with the neighboring solar cell are located, when the non-formed portion A3 is located at both ends of the first bus bar electrode 150b, the total area of the non-formed portion A3 where the front transparent conductive layer 140 is not formed can be reduced.

A width W1 in the first direction of the both ends of the first bus bar electrode 150b is larger than a width W2 in the first direction of a remaining portion which is located between the both ends along the second direction Y-Y.

Each of the both ends of the first bus bar electrode 150b is divided into both sides of the non-formed portion A3 along the first direction X-X. The non-formed portion A3 is located between the divided both ends. That is, the both ends of the first bus bar electrode 150b are not located in the non-formed portion A3. Thus, the both ends of the first bus bar electrode 150b are not physically in contact with the front doped layer located in the non-formed portion A3.

In this instance, the plurality of first finger electrode 150a may be located on the front transparent conductive layer of the edge region excluding the non-forming portion. The both ends of the divided first bus bar electrode 150b may extend to the edge region A1 and be physically connected to the first finger electrode 150a.

A width W3 in the first direction of the non-formed portion A3 may be less than the W2 in the first direction of the remaining portion of the first bus bar electrode 150b. A length L1 in the second direction of the non-formed portion A3 may be larger or smaller than an interval D1 between the two first finger electrodes 150a that is adjacent to each other in the second direction Y-Y. The length L1 in the second direction and the interval D1 may be equal to each other.

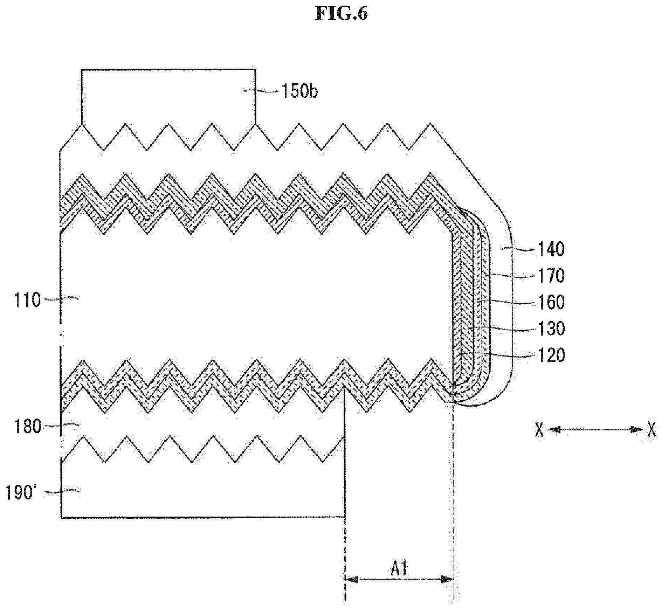

Hereinafter, a solar cell according to a third embodiment of the invention will be described with reference to FIG. 6.

FIG. 6 is a cross-sectional view of a solar cell according to a third embodiment of the invention.

In describing the solar cell of the third embodiment, since a front surface structure of the solar cell is configured in the same manner as the first embodiment or the second embodiment, only a back surface structure of the solar cell will be described below, and structures and components identical or equivalent to those of the first and second embodiments may be briefly made or may be entirely omitted.

In the solar cell of the first embodiment, the back collector electrode 190 is composed of the plurality of second finger electrodes 190a and the second bus bar electrode 190b.

However, in the solar cell of the third embodiment, the back collector electrode 190' is composed of a sheet electrode which covers entirely the back surface of the back transparent conductive layer 180.

As described above, in the solar cell having the back collector electrode 190' as a sheet electrode, since light cannot be incident on the back surface of the semiconductor substrate 110, the solar cell having the back collector electrode 190' as a sheet electrode can be used as a mono-facial solar cell.

The above-described solar cells can be manufactured as a solar cell module by a modularization process.

The solar cell module can be manufactured by electrically connecting a plurality of solar cells using wirings (for example, interconnectors or ribbons), disposing the plurality of solar cells between a pair of substrates, and performing a lamination process in a state where a sealing material is disposed between the pair of substrates.

Hereinafter, a method of manufacturing the above-described solar cells will be briefly described.

First, a method of manufacturing the solar cell according to the first embodiment is described. The n-type single crystal silicon substrate is cleaned to remove impurities, and etching is performed using an etchant composed of an aqueous solution of sodium hydroxide. Thus, a semiconductor substrate 110 having texturing surfaces formed on front and back surfaces of the silicon substrate is prepared.

Next, for example, using radio-frequency (RF) plasma chemical vapor deposition (CVD) method, a front passivation layer 120 made of i-type amorphous silicon and a front doped layer 130 made of p-type amorphous silicon are sequentially formed on the front surface and the side surface of the substrate 110, and a back passivation layer 160 made of i-type amorphous silicon and a back doped layer 170 made of n-type amorphous silicon are sequentially formed on the back surface and the side surface of the substrate 110.

Thus, the front passivation layer 120, the front doped layer 130, the back passivation layer 160, and the back doped layer 170 overlap each other on the side surface of the semiconductor substrate 110.

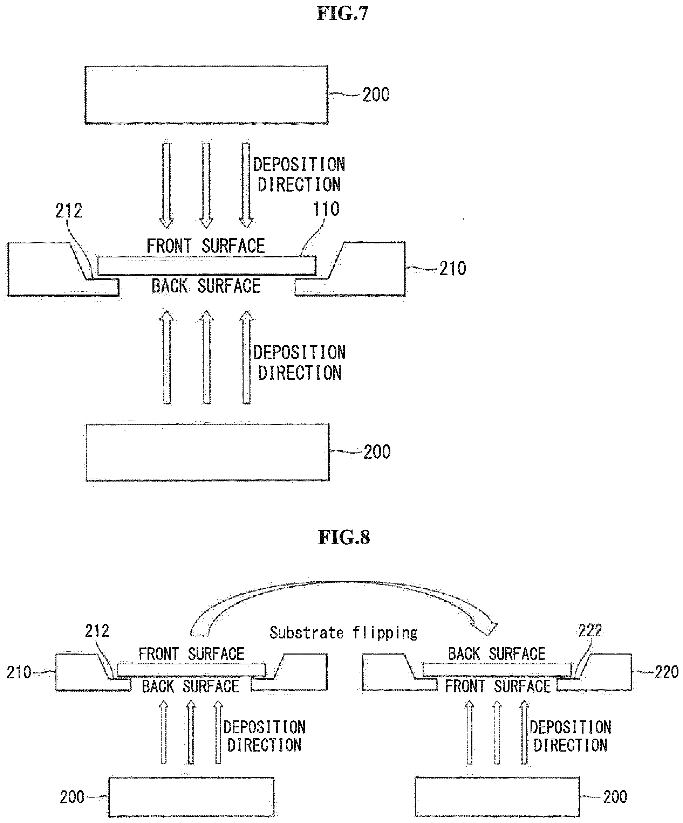

Then, using a sputtering device shown in FIG. 7, a front transparent conductive layer 140 is formed on the front doped layer 130 and a back transparent conductive layer 180 is formed on the back surface of the back doped layer 170.

The sputtering device shown in FIG. 7 is a device capable of simultaneously forming transparent conductive layers 140 and 180 on both surfaces of the semiconductor substrate 110, that is, a front surface and a back surface. Each of the sputtering targets 200 is located above the front surface and below the back surface of the semiconductor substrate 110 placed on a tray 210.

Therefore, when the sputtering device shown in FIG. 7 is used, the front transparent conductive layer 140 and the back transparent conductive layer 180 can be simultaneously formed in the same sputtering process.

In this instance, the tray 210 holding the semiconductor substrate 110 has a contact portion 212 that is physically and directly in contact with the back surface of the semiconductor substrate 110. The contact portion 212 is formed as a shape that covers the edge region A1 of the back surface of the semiconductor substrate 110.

Therefore, when the front transparent conductive layer 140 and the back transparent conductive layer 180 are formed using the sputtering device shown in FIG. 7, the front transparent conductive layer 140 is formed entirely in the center region A2 and the edge region A1 of the front surface of the semiconductor substrate 110 and extends to the side surface of the semiconductor substrate 110. The back transparent conductive layer 180 is formed only in the central region A2 of the back surface of the semiconductor substrate 110.

An annealing process may be performed for a predetermined time at a predetermined temperature to crystallize the front transparent conductive layer 140 and the back transparent conductive layer 180 formed by the manufacturing method described above.

Then, using a screen printing method, a silver (Ag) paste formed by mixing a silver (Ag) powder into a thermosetting resin such as an epoxy resin is formed on a predetermined region of the front transparent conductive layer 140 and the back transparent conductive layer 180 (more specifically, the finger electrode region and the bus bar electrode region on the front transparent conductive layer 140 and the back transparent conductive layer 180). By heating the silver (Ag) paste for a predetermined time at a predetermined temperature, the silver (Ag) paste is cured to form the plurality of finger electrodes 150a, the front collector electrode 150, the plurality of second finger electrodes 190a and the back collector electrode 190.

Hereinafter, a method of manufacturing the solar cell according to the second embodiment is described. Like the method of manufacturing the solar cell according to the first embodiment described above, a front passivation layer 120 made of i-type amorphous silicon and a front doped layer 130 made of p-type amorphous silicon are sequentially formed on the front surface and the side surface of the substrate 110, and a back passivation layer 160 made of i-type amorphous silicon and a back doped layer 170 made of n-type amorphous silicon are sequentially formed on the back surface and the side surface of the substrate 110.

Thus, the front passivation layer 120, the front doped layer 130, the back passivation layer 160, and the back doped layer 170 overlap each other on the side surface of the semiconductor substrate 110.

Then, using a remote plasma deposition (RPD) device shown in FIG. 8, a front transparent conductive layer 140 is formed on the front doped layer 130 and a back transparent conductive layer 180 is formed on the back surface of the back doped layer 170.

The RPD device shown in FIG. 8 is a device capable of sequentially forming transparent conductive layers 140 and 180 on both surfaces of the semiconductor substrate 110, that is, a front surface and a back surface by flipping the semiconductor substrate 110. The sputtering target 200 is located only below the back surface of the semiconductor substrate 110 placed on a tray 210 and 220.

Therefore, when the RPD device shown in FIG. 8 is used, the back transparent conductive layer 180 and the front transparent conductive layer 140 can be sequentially formed.

In this instance, the tray 210 holding the semiconductor substrate 110 to form the back transparent conductive layer 180 has a contact portion 212 that is physically and directly in contact with the back surface of the semiconductor substrate 110. The contact portion 212 is formed of a shape that covers the edge region A1 of the back surface of the semiconductor substrate 110.

The tray 220 holding the semiconductor substrate 110 to form the front transparent conductive layer 140 has a contact portion 222 that is physically and directly in contact with the front surface of the semiconductor substrate 110. The contact portion 222 is formed as a shape that covers the non-formed portion A3 in the edge region A1 of the first surface of the semiconductor substrate 110.

Therefore, when the back transparent conductive layer 180 are formed using the RPD device shown in FIG. 8, the back transparent conductive layer 180 may be formed only in the center region A2 of the back surface of the semiconductor substrate 110.

After forming the back transparent conductive layer 180, when the front transparent conductive layer 140 is formed in a state in which the semiconductor substrate 110 is placed on the tray 220 so that the front surface of the semiconductor substrate 110 is in contact with the contact portion 222 of the tray 220 by flipping the semiconductor substrate 110, the front transparent conductive layer 140 may be formed in the center region A2 of the front surface of the semiconductor substrate 110 and in the edge region A1 except for the non-formed portion A3.

Thereafter, if necessary, an annealing process for crystallizing the front transparent conductive layer 140 and the back transparent conductive layer 180 may be performed, and the front collector electrode 150 and the back collector electrode 190 may be formed using a screen printing method.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

Advantageous aspects of the present disclosure can be phrased as follows:
Aspect 1: A solar cell, comprising:
   a crystalline semiconductor substrate of a first conductive type;
   a front doped layer located on a front surface of the semiconductor substrate and forming a hetero junction with the semiconductor substrate;
   a back doped layer located on a back surface of the semiconductor substrate and forming a hetero junction with the semiconductor substrate;
   a front transparent conductive layer located on the front doped layer; and
   a back transparent conductive layer located under the back doped layer,
   wherein one of the front doped layer and the back doped layer has a second conductive type opposite the first conductive type to form a p-n junction with the semiconductor substrate, and the other of the front doped layer and the back doped layer has the first conductive type, and
   wherein a planar area of the front transparent conductive layer is larger than a planar area of the back transparent conductive layer.
Aspect 2: The solar cell of aspect 1, wherein a width in a first direction of the front transparent conductive layer is equal to or greater than a width in the first direction of the semiconductor substrate, and a width in the first direction and a width in a second direction orthogonal to the first direction of the back transparent conductive layer are less than a width in the first direction and a width in the second direction of the semiconductor substrate, respectively.
Aspect 3: The solar cell of aspect 2, wherein the front transparent conductive layer is not formed in at least a part of an edge region of the front surface of the semiconductor substrate, a region where the front transparent conductive layer is not formed is locally located in a part of the edge region of the front surface of the semiconductor substrate, and a plurality of regions where the front transparent conductive layer is not formed are spaced apart from each other.
Aspect 4: The solar cell of aspect 2 or 3, wherein the back transparent conductive layer is not formed in an edge region of the back surface of the semiconductor substrate, and a region where the back transparent conductive layer is not formed is continuously formed along an edge of the semiconductor substrate.
Aspect 5: The solar cell of any one preceding claim, wherein each of the front surface and the back surface of the semiconductor substrate includes an edge region that is continuously formed from an edge of the semiconductor substrate to an inside of the semiconductor substrate along the edge and a center region that is a remaining region except for the edge region,
   wherein the front transparent conductive layer is formed entirely in the edge region and the center region of the front surface of the semiconductor substrate, or formed in the center region and a remaining edge region except for a non-formed portion formed discontinuously in a part of the edge region of the front surface, and
   wherein the back transparent conductive layer is formed only in the center region except for the edge region of the back surface.
Aspect 6: The solar cell of aspect 5, wherein a width of the edge region of the back surface of the semiconductor substrate is 0.5 mm to 1.0 mm.
Aspect 7: The solar cell of aspect 5 or 6, wherein the semiconductor substrate contains an n-type impurity, the front doped layer is formed of p-type amorphous silicon containing a p-type impurity, and the back doped layer is formed of n-type amorphous silicon containing an n-type impurity.
Aspect 8: The solar cell of any one of aspects 5 to 7, further comprising:
   a front collector electrode located on the front transparent conductive layer; and
   a back collector electrode located under the back transparent conductive layer,
   wherein the front collector electrode is not physically and directly in contact with the front doped layer, and
   wherein the back collector electrode is not physically and directly in contact with the back doped layer.
Aspect 9: The solar cell of aspect 8, wherein the front collector electrode includes a plurality of first finger electrodes extending in a first direction, and at least one first bus bar electrode extending in a second direction and physically connected to the plurality of first finger electrodes, and
   wherein the back collector electrode includes a plurality of second finger electrodes extending in the first direction and at least one second bus bar electrode extending in the second direction and physically connected to the plurality of second finger electrodes, or includes a sheet electrode which covers entirely the back surface of a back transparent conductive layer.
Aspect 10: The solar cell of aspect 9, wherein the non-formed portion is located at both ends of the at least one first bus bar electrode, and a width in the first direction of the both ends of the first bus bar electrode is larger than a width in the first direction of a remaining portion located between the both ends along the second direction.
Aspect 11: The solar cell of aspect 10, wherein each of the both ends of the at least one first bus bar electrode is divided into both sides of the non-formed portion along the first direction, the non-formed portion is located between the divided both ends, the first finger electrodes located on the front transparent conductive layer of the edge region excluding the non-forming portion, and the both ends of the divided first bus bar electrode extend to the edge region and are physically connected to the first finger electrodes.
Aspect 12: The solar cell of aspect 10 or 11, wherein a width in the first direction of the non-formed portion is less than a width in the first direction of the remaining portion of the at least one first bus bar electrode, and a length in the second direction of the non-formed portion is smaller than an interval between two first finger electrodes that is adjacent to each other in the second direction.
Aspect 13: The solar cell of any one of aspects 9 to 12, further comprising:
   a front passivation layer located between the front doped layer and the semiconductor substrate, and
   a back passivation layer located between the back doped layer and the semiconductor substrate, and the front passivation layer and the back passivation layer are formed of intrinsic amorphous silicon or a tunnel oxide.
Aspect 14: The solar cell of aspect 13, wherein the front passivation layer, the back passivation layer, the front doped layer, and the back doped layer overlap each other on the side surface of the semiconductor substrate.
Aspect 15: The solar cell of aspect 14, wherein the front transparent conductive layer is further located on the front passivation layer, the back passivation layer, the front doped layer, and the back doped layer, which overlap each other on the side surface of the semiconductor substrate.

## Claims

1. A solar cell, comprising:
a crystalline semiconductor substrate (110) of a first conductive type, the semiconductor substrate (110) comprising a front surface and a back surface opposite the front surface, and each of the front surface and the back surface of the semiconductor substrate including an edge region (A1) that is continuously formed from an edge of the semiconductor substrate (110) to an inside of the semiconductor substrate (110) along the edge and a center region (A2) that is a remaining region except for the edge region (A1);
a front doped layer (130) located on the edge and center regions (A1, A2) of the front surface of the semiconductor substrate (110) and forming a hetero junction with the semiconductor substrate (110);
a front passivation layer (120) located between the front doped layer (130) and the semiconductor substrate (110);
a back doped layer (170) located on the edge and center regions (A1, A2) of the back surface of the semiconductor substrate (110) and forming a hetero junction with the semiconductor substrate (110);
a back passivation layer (160) located between the back doped layer (170) and the semiconductor substrate (110);
a front transparent conductive layer (140) located on the front doped layer (130); and
a back transparent conductive layer (180) located under the back doped layer (170),
wherein one of the front doped layer (130) and the back doped layer (170) has a second conductive type opposite the first conductive type to form a p-n junction with the semiconductor substrate (110), and the other of the front doped layer (130) and the back doped layer (170) has the first conductive type,
wherein a planar area of the front transparent conductive layer (140) is larger than a planar area of the back transparent conductive layer (180),
**characterized in that**
wherein the front and back passivation layers (120, 160) and the front transparent conductive layer (140) overlap each other at both side surfaces of the semiconductor substrate (110), and
wherein the front transparent conductive layer (140) is not formed in at least a part of the edge region (A1) of the front surface of the semiconductor substrate (110).

2. The solar cell of claim 1, wherein a width in a first direction (X-X) of the front transparent conductive layer (140) is equal to or greater than a width in the first direction (X-X) of the semiconductor substrate (110), and a width in the first direction and a width in a second direction (Y-Y) orthogonal to the first direction (X-X) of the back transparent conductive layer (180) are less than a width in the first direction (X-X) and a width in the second direction (Y-Y) of the semiconductor substrate (110), respectively.

3. The solar cell of claim 1 or 2, wherein a region (A3) where the front transparent conductive layer is not formed is locally located in a part of the edge region (A1) of the front surface of the semiconductor substrate (110), and a plurality of regions (A3) where the front transparent conductive layer (140) is not formed are spaced apart from each other.

4. The solar cell of any one preceding claim, wherein the back transparent conductive layer (180) is not formed in the edge region (A1) of the back surface of the semiconductor substrate (110), and a region (A1) where the back transparent conductive layer is not formed is continuously formed along the edge of the semiconductor substrate (110).

5. The solar cell of any one preceding claim, wherein the front transparent conductive layer (140) is formed in the center region (A2) and a remaining edge region except for a non-formed portion (A3) formed discontinuously in a part of the edge region (A1) of the front surface of the semiconductor substrate (110), and
wherein the back transparent conductive layer (180) is formed only in the center region (A2) except for the edge region (A1) of the back surface of the semiconductor substrate (110).

6. The solar cell of any one preceding claim, wherein a width of the edge region (A1) of the back surface of the semiconductor substrate (110) is 0.5 mm to 1.0 mm.

7. The solar cell of any one preceding claim, wherein the semiconductor substrate (110) contains an n-type impurity, the front doped layer (130) is formed of p-type amorphous silicon containing a p-type impurity, and the back doped layer (170) is formed of n-type amorphous silicon containing an n-type impurity.

8. The solar cell of any one preceding claim, further comprising:
a front collector electrode (150a, 150b) located on the front transparent conductive layer (140); and
a back collector electrode (190, 190') located under the back transparent conductive layer (180),
wherein the front collector electrode (150a, 150b) is not physically and directly in contact with the front doped layer (130), and
wherein the back collector electrode (190, 190') is not physically and directly in contact with the back doped layer (170).

9. The solar cell of claim 8, wherein the front collector electrode includes a plurality of first finger electrodes (150a) extending in a first direction (X-X), and at least one first bus bar electrode (150b) extending in a second direction (Y-Y) and physically connected to the plurality of first finger electrodes (150a), and
wherein the back collector electrode includes a plurality of second finger electrodes (190a) extending in the first direction (X-X) and at least one second bus bar electrode (190b) extending in the second direction (Y-Y) and physically connected to the plurality of second finger electrodes (190a), or includes a sheet electrode (190') which covers entirely the back surface of a back transparent conductive layer (180).

10. The solar cell of claim 9, wherein the non-formed portion (A3) is located at both ends of the at least one first bus bar electrode (150b), and a width (W1) in the first direction (X-X) of the both ends of the first bus bar electrode (150b) is larger than a width (W2) in the first direction (X-X) of a remaining portion located between the both ends along the second direction (Y-Y).

11. The solar cell of claim 10, wherein each of the both ends of the at least one first bus bar electrode (150b) is divided into both sides of the non-formed portion (A3) along the first direction (X-X), the non-formed portion (A3) is located between the divided both ends, the first finger electrodes (150a) located on the front transparent conductive layer (140) of the edge region (A1) excluding the non-forming portion (A3), and the both ends of the divided first bus bar electrode (150b) extend to the edge region (A1) and are physically connected to the first finger electrodes (150a).

12. The solar cell of claim 10, wherein a width (W3) in the first direction (X-X) of the non-formed portion (A3) is less than a width (W2) in the first direction (X-X) of the remaining portion of the at least one first bus bar electrode (150b), and a length (L1) in the second direction (Y-Y) of the non-formed portion (A3) is smaller than an interval (D1) between two first finger electrodes (150a) that is adjacent to each other in the second direction (Y-Y).

13. The solar cell of any one preceding claim, wherein the front passivation layer (120) and the back passivation layer (160) are formed of intrinsic amorphous silicon or a tunnel oxide.

14. The solar cell of claim 13, wherein the front doped layer (130) and the back doped layer (170) overlap each other at both side surfaces of the semiconductor substrate (110).
